# EUROPEAN PATENT APPLICATION

(11) **EP 4 615 204 A1**
(43) Date of publication of application: **10.09.2025**
(21) Application number: 23903886.2
(22) Date of filing: 07.12.2023
(51) Int. Cl.: H10K 50/84, G02B 1/14

(54) **OPTICAL FILM HAVING EXCELLENT CRUSH RESISTANCE AND DISPLAY DEVICE COMPRISING SAME**

(30) Priority: 14.12.2022 KR 20220174848; 04.12.2023 KR 20230173302
(71) Applicant: Kolon Industries, Inc., Seoul 07793 (KR)
(72) Inventor: SHIN, In Ho, Seoul 07793 (KR); YANG, Jong Won, Seoul 07793 (KR); KWON, Kyung Wook, Seoul 07793 (KR); KIM, Han Sol, Seoul 07793 (KR); PARK, Hyo Jun, Seoul 07793 (KR)
(74) Representative: Ter Meer Steinmeister & Partner
(86) International application number: PCT/KR2023/020110
(87) International publication number: WO 2024/128683

(57) **Abstract**

One embodiment of the present invention provides an optical film and a display device comprising the optical film, the optical film comprising: a light-transmissive matrix; and a filler dispersed in the light-transmissive matrix, wherein the optical film has a 1 mm dent strength of 10.7 N or more on the basis of a thickness of 50*µ*m.

## Description

### [Technical Field]

The present disclosure relates to an optical film and a display device including the same and more particularly, to an optical film having excellent dent resistance.

### [Background Art]

Recently, the use of an optical film instead of glass as a cover window of a display device has been considered with the goal of reducing thickness and weight and increasing the flexibility of the display device. In order for the optical film to be usable as a cover window of a display device, the optical film needs to have superior optical properties and excellent mechanical properties. For example, an optical film needs to have properties such as excellent strength, hardness, abrasion resistance, and flexibility.

Fillers may be added in order to impart desired physical properties to an optical film requiring various physical properties. The fillers may vary depending on physical properties required for the optical film.

### [Disclosure]

### [Technical Problem]

Therefore, the present disclosure has been made in view of the above problems, and it is one aspect of the present disclosure to provide an optical film that includes a fiber-shape filler dispersed in a light-transmitting matrix.

It is another aspect of the present disclosure to provide an optical film that includes a fiber-shape filler dispersed in a light-transmitting matrix and thus has excellent indentation hardness.

It is another aspect of the present disclosure to provide an optical film that includes a fiber-shape filler dispersed in a light-transmitting matrix and thus has excellent dent strength.

It is another aspect of the present disclosure to provide a display device including the optical film.

### [Technical Solution]

In accordance with one aspect of the present disclosure, provided is an optical film including a light-transmitting matrix and a filler dispersed in the light-transmitting matrix, the optical film having a 1 mm dent strength of 10.7 N or more, based on a thickness of 50 µm.

The 1 mm dent strength may refer to a force of an optical film to resist compression with a probe provided in a universal testing machine at a rate of 5 mm/min in a vertical direction from a point where a force of 1N is applied to a depth of 1 mm.

In an embodiment, the filler may have a rod or fiber shape.

In an embodiment, the filler may have a length of 1 to 10 µm.

In an embodiment, the filler may have a diameter of 3 to 330 nm.

In an embodiment, the filler may have an aspect ratio of 30 to 1,000.

The aspect ratio may refer to a ratio of a length of the filler to a diameter of the filler.

In an embodiment, the filler may include at least one of glass fiber, an aluminum-based fiber, titanium fiber or fluoride fiber.

In an embodiment, the filler may contain aluminum oxide hydroxide.

In an embodiment, a content of the filler may be 3 to 50 wt% based on a total weight of the optical film.

In an embodiment, the optical film may have a true density of 1.55 to 1.67 g/cm³.

In an embodiment, the optical film may have an HM of 220 MPa or more based on a thickness of 50 µm.

The HM may represent a Martens hardness of the optical film and the HM may be measured using HM-2000 at a force of 12 mN for a running time of 12s and for a hold time of 5s.

In an embodiment, the optical film may have an HV of 46 MPa or more.

The HV may represent a Vickers hardness of the optical film and the HV may be measured using HM-2000 at a force of 12 mN for a running time of 12 s and for a hold time of 5 s.

In an embodiment, the optical film may have a restoration rate (nIT) of 60 to 100%.

The restoration rate may be measured using a nanoindenter under the conditions of 12 mN/12s/creep 5s/24°C, 40 RH%.

In an embodiment, the light-transmitting matrix may include at least one of an imide repeating unit or an amide repeating unit.

In an embodiment, the light-transmitting matrix may be produced from a polymerizable composition containing a diamine-based monomer and at least one of a dianhydride-based compound or a dicarbonyl-based compound.

The diamine-based monomer may include at least one of 2,2'-bis(trifluoromethyl)benzidine (TFDB), 4,4'-oxydianiline (ODA), p-phenylenediamine (pPDA), m-phenylenediamine (mPDA), p-methylenediamine (pMDA), m-methylenediamine (mMDA), 1,3-bis(3-aminophenoxy)benzene (133APB), 1,3-bis(4-aminophenoxy)benzene (134APB), 2,2'-bis[4(4-aminophenoxy)phenyl]hexafluoropropane (4BDAF), 2,2'-bis(3-aminophenyl) hexafluoropropane (33-6F), 2,2'-bis(4-aminophenyl) hexafluoropropane (44-6F), bis(4-aminophenyl) sulfone (4DDS), bis(3-aminophenyl)sulfone (3DDS), 1,3-cyclohexanediamine (13CHD), 1,4-cyclohexanediamine (14CHD), 2,2-bis(4-(4-aminophenoxy) phenyl) propane (6HMDA), 2,2-bis(3-amino-4-hydroxyphenyl)hexafluoropropane (DBOH), or 4,4'-bis(3-aminophenoxy)diphenylsulfone (DBSDA).

The dianhydride-based compound may include at least one of 3,3,4,4-biphenyltetracarboxylic dianhydride (BPDA), 2,2-bis(3,4-dicarboxyphenyl)hexafluoropropane dianhydride (6FDA), 4-(2,5-dioxotetrahydrofuran-3-yl)-1,2,3,4-tetrahydronaphthalene-1,2-dicarboxylic anhydride (TDA), pyromellitic dianhydride (1,2,4,5-benzene tetracarboxylic dianhydride, PMDA), 3,3,4,4-benzophenone tetracarboxylic dianhydride (BTDA), 4,4-oxydiphthalic dianhydride (ODPA), bis(3,4-dicarboxyphenyl)dimethyl-silane dianhydride (SiDA), 4,4-bis(3,4-dicarboxyphenoxy) diphenyl sulfide dianhydride (BDSDA), sulfonyldiphthalic anhydride (SO2DPA), cyclobutane-1,2,3,4-tetracarboxylic dianhydride (CBDA), or 4,4'-(4,4'-isopropylenediphenoxy) bis(phthalic anhydride) (6HBDA).

The dicarbonyl-based compound may include at least one of terephthaloyl chloride (TPC), phthaloyl chloride, isophthaloyl chloride (IPC), biphenyldicarbonyl chloride (DPDOC), 4,4'-oxybis(benzoyl chloride) (OBBOC), naphthalene-2,3-dicarbonyl dichloride, or 1,4-cyclohexanedicabonyldichloride (CHDOC).

In an embodiment, a molar ratio of the dianhydride-based compound and the dicarbonyl-based compound may be 5:95 to 40:60.

In accordance with another aspect of the present disclosure, provided is a display device including a display panel and the optical film disposed on the display panel.

### [Advantageous Effects]

According to one embodiment of the present disclosure, the filler included in the optical film has a rod or fiber shape and can engage the polymer chains constituting the light-transmitting matrix. As a result, the mechanical strength of the optical film can be improved.

When the optical film according to an embodiment of the present disclosure is used for the display device, for example, when external force is applied to the display device using a touch pen, or the like, deformation can be prevented or suppressed, and the resistance to deformation can be improved. In addition, when a continuous external force is applied under the same conditions, the degree of deformation may decrease.

### [Description of Drawings]

FIG. 1 is a schematic diagram illustrating an optical film according to an embodiment of the present disclosure.
FIG. 2 is a cross-sectional view illustrating a part of a display device according to another embodiment of the present disclosure.
FIG. 3 is an enlarged cross-sectional view illustrating part "P" in FIG. 2.

### [Best Mode]

Hereinafter, embodiments of the present disclosure will be described in detail with reference to the accompanying drawings. However, the following embodiments are illustratively provided merely for clear understanding of the present disclosure and do not limit the scope of the present disclosure.

The shapes, sizes, ratios, angles, and numbers disclosed in the drawings for describing embodiments of the present disclosure are merely examples, and the present disclosure is not limited to the illustrated details. Like reference numerals refer to like elements throughout the present specification. In the following description, when a detailed description of relevant known functions or configurations is determined to unnecessarily obscure important points of the present disclosure, the detailed description will be omitted.

In the case in which a term such as "comprise", "have", or "include" is used in the present specification, another part may also be present, unless "only" is also used. Terms in a singular form may include the plural meanings, unless noted to the contrary. Also, in construing an element, the element is to be construed as including an error range, even if there is no explicit description thereof.

In describing a positional relationship, for example, when the positional relationship is described using "on", "above", "below", or "next to", the case of no contact therebetween may be included, unless "immediately" or "directly" is used.

Spatially relative terms, such as "below", "beneath", "lower", "above", and "upper", may be used herein to describe the relationship between a device or element and another device or element, as shown in the figures. It will be understood that spatially relative terms are intended to encompass different orientations of a device during the use or operation of the device, in addition to the orientation depicted in the figures. For example, if a device in one of the figures is turned upside down, elements described as "below" or "beneath" other elements would then be positioned "above" the other elements. The exemplary term "below" or "beneath" can, therefore, encompass the meanings of both "below" and "above". In the same manner, the exemplary term "above" or "upper" can encompass the meanings of both "above" and "below".

In describing temporal relationships, for example, when a temporal order is described using "after", "subsequent", "next", or "before", the case of a non-continuous relationship may be included, unless "immediately" or "directly" is used.

It will be understood that, although the terms "first", "second", etc. may be used herein to describe various elements, these elements are not limited by these terms. These terms are only used to distinguish one element from another. Therefore, a first element could be termed a second element within the technical idea of the present disclosure.

It should be understood that the term "at least one" includes all combinations related with one or more items. For example, "at least one among a first element, a second element, and a third element" may include all combinations of two or more elements selected from among the first, second, and third elements, as well as each of the first, second, and third elements.

Features of various embodiments of the present disclosure may be partially or completely integrated or combined with each other, and may be variously interoperated with each other and driven technically. The embodiments of the present disclosure may be carried out independently from each other, or may be carried out together in an interrelated manner.

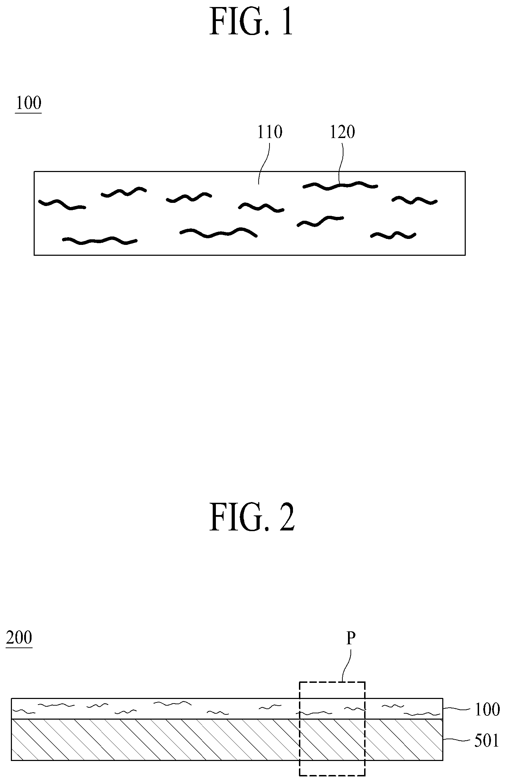

FIG. 1 is a schematic diagram illustrating an optical film 100 according to an embodiment of the present disclosure.

According to one embodiment of the present disclosure, a film having light transmittance is referred to as an "optical film 100".

The optical film 100 according to an embodiment of the present disclosure includes a light-transmitting matrix 110 and a filler 120 dispersed in the light-transmitting matrix 110.

The light-transmitting matrix 110 may be light-transmitting. According to an embodiment of the present disclosure, the light-transmitting matrix 110 may be flexible. For example, the optical film 100 according to an embodiment of the present disclosure may be bendable, foldable, or rollable. As a result, the optical film 100 according to an embodiment of the present disclosure may be light-transmitting and may be bendable, foldable, or rollable.

According to an embodiment of the present disclosure, the light-transmitting matrix 110 may include at least one of an imide repeating unit or an amide repeating unit.

The light-transmitting matrix 110 according to an embodiment of the present disclosure may be produced from ingredients including a dianhydride-based compound and a diamine monomer. Specifically, the light-transmitting matrix 110 may include an imide repeating unit formed by a dianhydride-based compound and a diamine-based monomer.

However, the light-transmitting matrix 110 according to an embodiment of the present disclosure is not limited thereto and the light-transmitting matrix 110 may be produced from ingredients including a dicarbonyl-based compound and a diamine-based monomer. Specifically, the light-transmitting matrix 110 may include an amide repeating unit formed by a dicarbonyl-based compound and a diamine-based monomer.

In addition, the light-transmitting matrix 110 according to an embodiment of the present disclosure may be produced from ingredients including a dicarbonyl-based compound in addition to a dianhydride-based compound and a diamine-based monomer. The light-transmitting matrix 110 according to an embodiment of the present disclosure may have an imide repeating unit and an amide repeating unit. For example, the light-transmitting matrix 110 having an imide repeating unit and an amide repeating unit may be a polyamide-imide resin.

According to one embodiment of the present disclosure, the light-transmitting matrix 110 may include a polyimide-based polymer. Examples of the polyimide-based polymer may include polyimide polymers, polyamide-imide polymers and the like. The light-transmitting matrix 110 according to an embodiment of the present disclosure may be produced from, for example, a polyimide-based polymer resin.

According to one embodiment of the present disclosure, the light-transmitting matrix 110 may be formed from a polymerizable composition containing a diamine-based monomer, and at least one of a dianhydride-based compound or a dicarbonyl-based compound.

The polymerizable composition according to an embodiment of the present disclosure may include a diamine-based monomer.

According to an embodiment of the present disclosure, for example, the diamine-based monomer may include at least one of 2,2'-bis(trifluoromethyl)benzidine (TFDB), 4,4'-oxydianiline (ODA), p-phenylenediamine (pPDA), m-phenylenediamine (mPDA), p-methylenediamine (pMDA), m-methylenediamine (mMDA), 1,3-bis(3-aminophenoxy)benzene (133APB), 1,3-bis(4-aminophenoxy)benzene (134APB), 2,2'-bis[4(4-aminophenoxy)phenyl] hexafluoropropane (4BDAF), 2,2'-bis(3-aminophenyl) hexafluoropropane (33-6F), 2,2'-bis(4-aminophenyl) hexafluoropropane (44-6F), bis(4-aminophenyl) sulfone (4DDS), bis(3-aminophenyl)sulfone (3DDS), 1,3-cyclohexanediamine (13CHD), 1,4-cyclohexanediamine (14CHD), 2,2-bis(4-(4-aminophenoxy) phenyl) propane (6HMDA), 2,2-bis(3-amino-4-hydroxyphenyl)hexafluoropropane (DBOH), or 4,4'-bis(3-aminophenoxy)diphenylsulfone (DBSDA).

More specifically, according to an embodiment of the present disclosure, for example, the diamine-based compound may include at least one of 2,2'-bis(trifluoromethyl)benzidine (TFDB), 2,2'-bis(3-aminophenyl)hexafluoropropane (33-6F), 2,2'-bis(4-aminophenyl)hexafluoropropane (44-6F), bis(4-aminophenyl) sulfone (4DDS), bis(3-aminophenyl)sulfone (3DDS), or 4,4'-bis(3-aminophenoxy)diphenylsulfone (DBSDA), but one embodiment of the present disclosure is not limited thereto.

The polymerizable composition according to an embodiment of the present disclosure may include at least one of a dianhydride-based compound or a dicarbonyl-based compound.

According to one embodiment of the present disclosure, the dianhydride-based compound may, for example, include 3,3,4,4-biphenyltetracarboxylic dianhydride (BPDA), 2,2-bis(3,4-dicarboxyphenyl)hexafluoropropane dianhydride (6FDA), 4-(2,5-dioxotetrahydrofuran-3-yl)-1,2,3,4-tetrahydronaphthalene-1,2-dicarboxylic anhydride (TDA), pyromellitic dianhydride (1,2,4,5-benzene tetracarboxylic dianhydride, PMDA), 3,3,4,4-benzophenone tetracarboxylic dianhydride (BTDA), 4,4-oxydiphthalic dianhydride (ODPA), bis(3,4-dicarboxyphenyl)dimethyl-silane dianhydride (SiDA), 4,4-bis(3,4-dicarboxyphenoxy) diphenyl sulfide dianhydride (BDSDA), sulfonyldiphthalic anhydride (SO2DPA), cyclobutane-1,2,3,4-tetracarboxylic dianhydride (CBDA), or 4,4'-(4,4'-isopropylinediphenoxy)bis(phthalic anhydride) (6HBDA).

More specifically, according to one embodiment of the present disclosure, the dianhydride-based compound may, for example, include at least one of 3,3,4,4-biphenyltetracarboxylic dianhydride (BPDA), 2,2-bis(3,4-dicarboxyphenyl)hexafluoropropane dianhydride (6FDA), pyromellitic dianhydride (1,2,4,5-benzene tetracarboxylic dianhydride, PMDA), 3,3,4,4-benzophenone tetracarboxylic dianhydride (BTDA), 4,4-oxydiphthalic dianhydride (ODPA), or cyclobutane-1,2,3,4-tetracarboxylic dianhydride (CBDA), but one embodiment of the present disclosure is not limited thereto.

According to one embodiment of the present disclosure, the dicarbonyl-based compound may, for example, include at least one of terephthaloyl chloride (TPC), phthaloyl chloride, isophthaloyl chloride (IPC), biphenyldicarbonyl chloride (DPDOC), 4,4'-oxybis(benzoyl chloride) (OBBOC), naphthalene-2,3-dicarbonyl dichloride, or 1,4-cyclohexanedicabonyldichloride (CHDOC).

More specifically, according to one embodiment of the present disclosure, the dicarbonyl-based compound may, for example, include terephthaloyl chloride (TPC), phthaloyl chloride, or isophthaloyl chloride, but one embodiment of the present disclosure is not limited thereto.

According to one embodiment of the present disclosure, the total equivalent weight of the dianhydride-based compound and the dicarbonyl-based compound may be substantially the same as the equivalent weight of the diamine-based monomer.

The polymerizable composition according to an embodiment of the present disclosure may contain 60 mol% or more of the dicarbonyl-based compound with respect to the total number of moles of the dianhydride-based compound and the dicarbonyl-based compound in order to secure excellent mechanical properties.

For example, the molar ratio of the dianhydride-based compound and the dicarbonyl-based compound may be in the range of 5:95 to 40:60.

The light-transmitting matrix 110 may have a thickness sufficient for the optical film 100 to protect the display panel. For example, the light-transmitting matrix 110 may have a thickness of 10 to 100 µm. The thickness of the light-transmitting matrix 110 may be the same as that of the optical film 100.

The filler 120 may have a rod or fiber shape. Hereinafter, a shape having a length greater than a diameter is referred to as a "fiber shape". The fiber shape may also be referred to as a "filament shape". According to one embodiment of the present disclosure, the length of the filler 120 may be more than twice the diameter thereof.

According to one embodiment of the present disclosure, the filler 120 is arranged in parallel with the polymer resin contained in the light-transmitting matrix 110. For example, the filler 120 may be bound to the main chain of the polymer resin through a secondary bond such as a hydrogen bond or a dipole moment, and may be arranged in parallel with the main chain in the same direction as in the main chain.

According to one embodiment of the present disclosure, the filler 120 has a fiber shape and thus can engage (or link, or connected) the polymer chains constituting the light-transmitting matrix 110. As a result, the stability and arrangement characteristics of the polymer chains can be improved, the mechanical properties of the light-transmitting matrix 110 can be improved, and the mechanical properties of the optical film 100 can also be improved.

According to one embodiment of the present disclosure, the aspect ratio of the filler 120 may range from 30 to 1,000. The aspect ratio refers to a ratio of the length to the diameter of the filler 120.

When the aspect ratio of the filler 120 is less than 30, the filler 120 is not long enough and cannot sufficiently perform the function of engaging the polymer chains to each other and thus cannot sufficiently exert the function of improving the stability and arrangement characteristics of the polymer chains.

When the aspect ratio of the filler 120 is greater than 1,000, the filler 120 may reduce the dispersibility of the filler 120 and cause agglomeration of the filler 120 within the light-transmitting matrix 110 due to excessively great length. As a result, the optical film 100 may have decreased light transmittance, increased haze and deteriorated optical properties. In addition, the mechanical strength of the optical film 100 may decrease in the area where agglomeration of the filler 120 occurs.

According to one embodiment of the present disclosure, the length of the filler 120 may range from 1 to 10 µm.

When the length of the filler 120 is less than 1 µm, the function of the filler 120 to engage the polymer chains may not be sufficiently exerted.

When the length of the filler 120 is higher than 10 µm, the dispersibility of the filler 120 may decrease, and as a result, agglomeration of the filler 120 may occur within the light-transmitting matrix 110 and gelation may readily occur due to interaction with the polymer chains. Accordingly, the optical film 100 may have decreased light transmittance, increased haze and deteriorated optical properties.

According to one embodiment of the present disclosure, the diameter of the filler 120 may range from 3 to 330 nm.

When the diameter of the filler 120 is less than 3 nm, the stability of the filler 120 may decrease and the filler 120 may be cut or broken. Also, the filler 120 may contaminate the optical film 100 and increasing the haze of the optical film 100.

When the diameter of the filler 120 is higher than 330 nm, the filler 120 has difficulty in having a fiber shape and the optical film 100 may have increased haze and decreased transmittance.

There is no particular limitation on the type of filler 120. Any filler may be used without limitation as the filler 120 according to an embodiment of the present disclosure so long as it has a fiber shape. The filler 120 may be inorganic or organic. The filler 120 may include at least one of inorganic fibers, organic fibers, or organic-inorganic hybrid fibers.

More specifically, the filler 120 may have a fiber shape. For example, the filler 120 may have a single-stranded fiber shape, a multi-stranded fiber shape, or a branch shape in which multiple strands are arranged in the form of branches based on one central strand.

According to one embodiment of the present disclosure, the filler 120 may include at least one of glass fiber, an aluminum-based fiber, titanium fiber or fluoride fiber.

The glass fiber may contain SiO₂ and may further contain other components in addition to SiO₂. The aluminum-based fiber contains aluminum oxide hydroxide (AlO(OH)). The aluminum-based fiber may further contain other components in addition to aluminum oxide hydroxide (AlO(OH)). The titanium fiber may contain TiO₂. The titanium fiber may contain other components in addition to TiO₂. The fluoride fiber may contain at least one of polytetrafluoroethylene (PTFE) or polyvinylidene fluoride (PVDF) and may further contain other components in addition to PTFE and PVDF.

According to one embodiment of the present disclosure, the filler 120 may include an aluminum-based fiber. The aluminum-based fiber may include aluminum oxide hydroxide.

According to one embodiment of the present disclosure, the filler 120 may include aluminum oxide hydroxide. Aluminum oxide hydroxide is also called "Boehmite" and may be represented by γ-AlO(OH). More specifically, aluminum oxide hydroxide may include a unit structure represented by any of the following Formulas 1, 2, and 3. 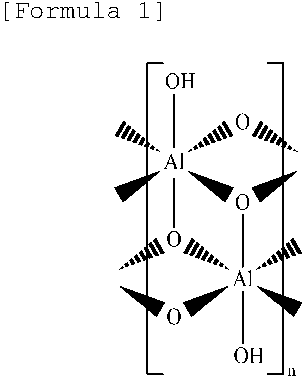 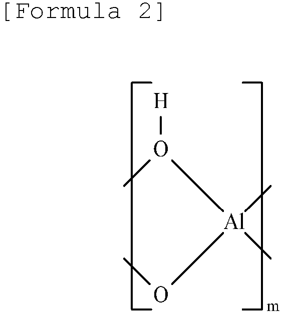 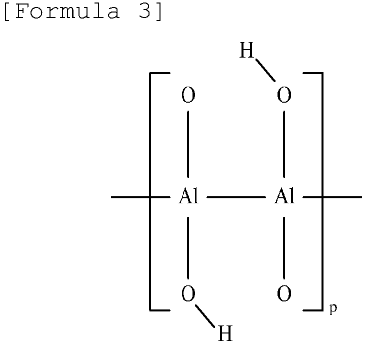 wherein n ranges from 50 to 10,000, m ranges from 50 to 10,000, and p ranges from 100 to 20,000.

When the structures of Formulas 1, 2 and 3 are expanded for better understanding of the structure of the filler 120, the filler 120 may be represented by any one of Formulas 4, 5 and 6.

The structure represented by Formula 1 may be represented by, for example, Formula 4 below. Formula 4 below corresponds to the structure of Formula 1 wherein n is 5.

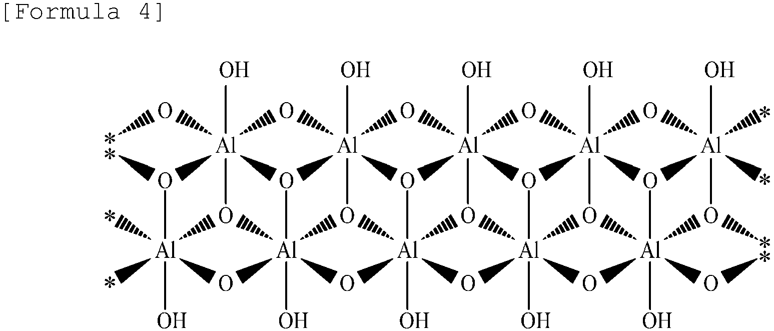

The structure represented by Formula 2 may be represented by, for example, Formula 5 below. Formula 5 below corresponds to the structure of Formula 2 wherein m is 4.

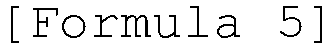

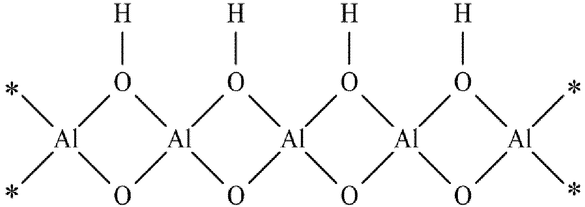

The structure represented by Formula 3 may be represented by, for example, Formula 6 below. Formula 6 below corresponds to the structure of Formula 3 wherein p is 3.

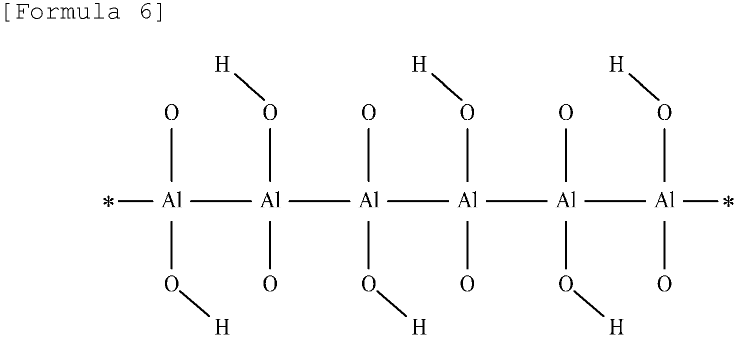

In Formulas 4 to 6, "*" represents a binding position.

According to an embodiment of the present disclosure, SiO₂ may have a unit structure represented by Formula 7 below.

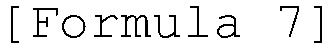

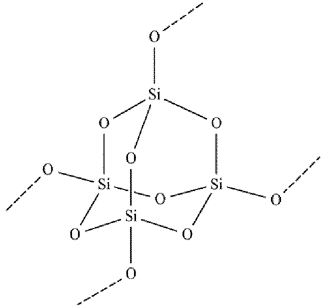

According to one embodiment of the present disclosure, the filler 120 may be surface-treated. For example, the filler 120 may be surface-treated with an organic compound having an alkoxy group.

According to an embodiment of the present disclosure, the filler 120 may cause appropriate light scattering to improve the optical properties of the optical film 100. To enhance the light scattering effect, the content of the filler 120 in the optical film 100 may be adjusted.

According to one embodiment of the present disclosure, the content of the filler 120 may be 3 to 50 wt%, based on the total weight of the optical film 100. More specifically, the content of the filler 120 may be adjusted to 4 to 30 wt%, or may be 5 to 20 wt%, based on the total weight of the optical film 100.

When the content of the filler 120 is less than 3 wt%, based on the total weight of the optical film 100, the light scattering effect by the filler 120 is insufficient, so the effect of improving the light transmittance of the optical film 10 cannot be obtained and the filler 120 cannot sufficiently exert the function of engaging the polymer chains.

On the other hand, when the content of the filler 120 is higher than 50 wt%, based on the total weight of the optical film 100, the dispersibility of the filler 120 may decrease, the haze of the optical film 100 may decrease, agglomeration of the filler 120 may occur due to the excessive amount of the filler 120, and the agglomerated filler 120 blocks light, which may reduce the light transmittance of the optical film 100.

The true density of the optical film 100 according to an embodiment of the present disclosure may be 1.55 to 1.67 g/cm³.

True density refers to a density of solid excluding the voids of the optical film 100, and when a material is small, true density refers to a density of only a portion exclusively filled with the material excluding the voids between particles. According to one embodiment of the present disclosure, the true density refers to a density of only a part filled with the light-transmitting matrix 110 and the filler 120 excluding the voids. The true density of the optical film 100 may be measured using, for example, an Accupyc II 1340 pycnometer.

When the filler 120 according to an embodiment of the present disclosure has a fiber shape, it may have a higher true density at the same weight than a spherical filler. For example, the true density of the optical film 100 when the fiber-shape filler 120 is added in an amount of 20% of the total weight, is equal to the true density of the optical film 100 when the spherical filler 120 is added in an amount of 40% of the total weight. Therefore, the fiber-shape filler 120 may be advantageous in terms of not only mechanical properties but also optical properties.

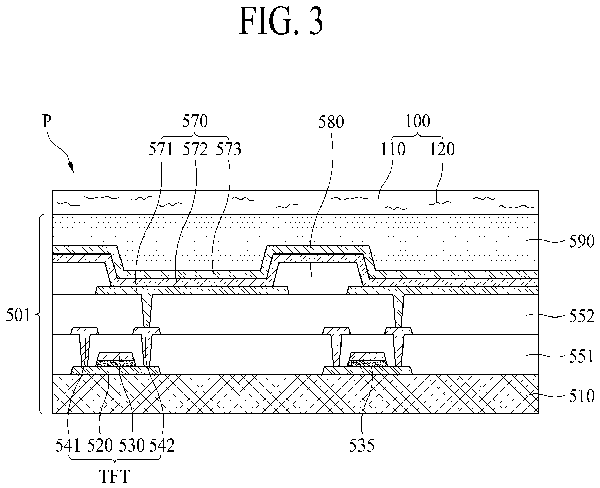

FIG. 2 is a cross-sectional view illustrating a part of a display device 200 according to another embodiment of the present disclosure and FIG. 3 is an enlarged cross-sectional view of "P" in FIG. 2.

Referring to FIG. 2, the display device 200 according to another embodiment of the present disclosure includes a display panel 501 and an optical film 100 on the display panel 501.

Referring to FIGs. 2 and 3, the display panel 501 includes a substrate 510, a thin film transistor TFT on the substrate 510, and an organic light-emitting device 570 connected to the thin film transistor TFT. The organic light-emitting device 570 includes a first electrode 571, an organic light-emitting layer 572 on the first electrode 571, and a second electrode 573 on the organic light-emitting layer 572. The display device 200 shown in FIGs. 2 and 3 is an organic light-emitting display device.

The substrate 510 may be formed of glass or plastic. Specifically, the substrate 510 may be formed of plastic such as a polyimide-based resin or an optical film. Although not shown, a buffer layer may be disposed on the substrate 510.

The thin film transistor TFT is disposed on the substrate 510. The thin film transistor TFT includes a semiconductor layer 520, a gate electrode 530 that is insulated from the semiconductor layer 520 and at least partially overlaps the semiconductor layer 520, a source electrode 541 connected to the semiconductor layer 520, and a drain electrode 542 that is spaced apart from the source electrode 541 and is connected to the semiconductor layer 520.

Referring to FIG. 3, a gate insulating layer 535 is disposed between the gate electrode 530 and the semiconductor layer 520. An interlayer insulating layer 551 may be disposed on the gate electrode 530, and the source electrode 541 and the drain electrode 542 may be disposed on the interlayer insulating layer 551.

A planarization layer 552 is disposed on the thin film transistor TFT to planarize the top of the thin film transistor TFT.

A first electrode 571 is disposed on the planarization layer 552. The first electrode 571 is connected to the thin film transistor TFT through a contact hole provided in the planarization layer 552.

A bank layer 580 is disposed on the planarization layer 552 in a part of the first electrode 571 to define pixel areas or light-emitting areas. For example, the bank layer 580 is disposed in the form of a matrix at the boundaries between a plurality of pixels to define the respective pixel regions.

The organic light-emitting layer 572 is disposed on the first electrode 571. The organic light-emitting layer 572 may also be disposed on the bank layer 580. The organic light-emitting layer 572 may include one light-emitting layer, or two or more light-emitting layers stacked in a vertical direction. Light having any one color among red, green, and blue may be emitted from the organic light-emitting layer 572, and white light may be emitted therefrom.

The second electrode 573 is disposed on the organic light-emitting layer 572.

The first electrode 571, the organic light-emitting layer 572, and the second electrode 573 may be stacked to constitute the organic light-emitting device 570.

Although not shown, when the organic light-emitting layer 572 emits white light, each pixel may include a color filter for filtering the white light emitted from the organic light-emitting layer 572 based on a particular wavelength. The color filter is formed on the light path.

A thin-film encapsulation layer 590 may be disposed on the second electrode 573. The thin-film encapsulation layer 590 may include at least one organic layer and at least one inorganic layer, and the at least one organic layer and the at least one inorganic layer may be alternately disposed.

The optical film 100 is disposed on the display panel 501 having the stack structure described above. The optical film 100 includes a light-transmitting matrix 110 and a filler 120 dispersed in the light-transmitting matrix 110.

The optical film 100 according to an embodiment of the present disclosure may have an HM of 220 MPa or more, based on a thickness of 50 µm. The HM means a Martens hardness of the optical film 100 according to an embodiment of the present disclosure. The unit of Martens hardness is defined as MPa.

The Martens hardness of the optical film 100 according to an embodiment of the present disclosure is obtained by measuring surface hardness to the indentation formed by pressing the light-transmitting matrix 110 with a pyramidal diamond tip, calculating HM = A/B wherein the load is A kg and the surface area is B mm², and then converting the result into MPa. The Martens hardness may be measured under conditions of 12 mN/running time 12s/hold time 5s.

The Martens hardness of the optical film 100 may be measured using a Martens hardness meter, for example, HM-2000 from Fisher Scientific International, Inc.

The optical film 100 according to an embodiment of the present disclosure may have an HM of 220 to 300 MPa. More specifically, the optical film 100 may have an HM of 240 to 280 MPa.

When the HM of the optical film 100 is less than 220 MPa, the optical film 100 may be vulnerable to external indentations. For example, when an external force is applied to the outside of the optical film 100, the optical film 100 may be readily scratched or crack.

The optical film 100 according to an embodiment of the present disclosure may have an HV of 46 or more, based on a thickness of 50 µm. The HV means the Vickers hardness of the optical film 100 according to an embodiment of the present disclosure.

The Vickers hardness of the optical film 100 according to an embodiment of the present disclosure is obtained by measuring the surface hardness to the indentation created by pressing the light-transmitting matrix 110 with a pyramidal diamond tip, and calculating HV = C/D, wherein the load is C kg and the surface area is D mm². The Vickers hardness may be measured under the conditions of 12 mN/running time 12s/hold time 5s.

The Vickers hardness of the optical film 100 may be measured using a Vickers hardness meter, for example, HM-2000 from Fisher Scientific International, Inc.

When the HV of the optical film 100 is less than 46, the optical film 100 may be vulnerable to external indentations. For example, when an external force is applied to the outside of the optical film 100, the optical film 100 may be readily scratched or crack.

The optical film 100 according to an embodiment of the present disclosure may have a 1 mm dent strength of 10.7N or more based on 50 µm. The basic unit of 1 mm dent strength is defined as N.

The term "1 mm dent strength" may be defined as the force of the optical film 100 to resist compression in the vertical direction from a point where a force of 1N is applied to a depth of 1 mm.

The 1 mm dent strength is an indicator of the surface hardness of the optical film 100. An excellent 1 mm dent strength means high resistance to external force.

The 1 mm dent strength may be measured, for example, as follows: first, the optical film 100 according to an embodiment of the present disclosure is produced into a sample with a size of 60 mm x 60 mm. The produced sample for the optical film 100 is placed on a fixture with a circular hole in the center and then the sample for the optical film 100 is fixed with a clamp. The sample for the optical film 100 is pressed with a probe having a cylindrical head with a diameter of 1.59 mm mounted on a universal testing machine in the vertical direction at a speed of 5 mm/min. The force measured upon pressing from the point where a force of 1N is applied to the probe as a reference point to a depth of 1 mm may be measured as the 1 mm dent strength of the optical film 100. For example, the universal testing machine, fixed support (S1-11855), clamp and probe (2830-005) from Instron Corporation may be used to measure the 1 mm dent strength.

When the 1 mm dent strength of the optical film 100 is less than 10.7 N, for example, when the optical film 100 is used as a cover window of a display device 200, indentations, scratches, or the like may be formed by external force generated from a touch pen, fingernail, foreign matter, or the like on the cover window, which may deteriorate the exterior quality of the cover window.

The optical film 100 according to an embodiment of the present disclosure may have a restoration rate (nIT) of 60 to 100%. The basic unit of the restoration rate is defined as percentage (%).

The restoration rate of the optical film 100 is determined by, for example, applying a load of 12 mN to the optical film 100 for 12 seconds at a temperature of 24°C and at a humidity of 40 RH% using a nanoindenter, pressing the optical film 100, allowing the optical film 100 to stand at the maximum pressed point for 5 seconds, and then measuring the degree to which the optical film 100 has been depressed when the applied load is reversely removed (12 mN/12s/creep 5s/24°C, 40 RH%). The nanoindenter used herein may be, for example, a model HM2000 from Fischer.

When the restoration rate of the optical film 100 is less than 60%, the optical film 100 lacks recovery force when unfolded, thus causing folding indentations or press indentations to remain and making application to a foldable or rollable display difficult.

Hereinafter, a method of manufacturing an optical film 100 according to another embodiment of the present disclosure will be described.

The method of manufacturing an optical film 100 according to an embodiment of the present disclosure includes preparing a polyimide-based resin powder, preparing a light-transmitting resin solution using the polyimide-based resin powder, preparing a filler dispersion, mixing the filler dispersion with the polyimide-based resin solution to prepare a filler resin mixture, in which the filler 120 is dispersed, and producing an optical film 100 using the prepared filler resin mixture. Hereinafter, each step will be described in detail.

According to one embodiment of the present disclosure, the polyimide-based resin solution may be used as the resin solution for forming the light-transmitting matrix 110.

The method of manufacturing the optical film 100 according to an embodiment of the present disclosure includes preparing a polyimide-based resin powder.

More specifically, according to an embodiment of the present disclosure, the preparing a polyimide-based resin powder includes preparing a first reaction solution using a diamine-based monomer and a dianhydride-based compound, adding a dicarbonyl-based compound to the first reaction solution, followed by reaction to prepare a second reaction solution, adding a dehydrating agent and an imidization catalyst to the second reaction solution, followed by reaction to prepare a third reaction solution, and treating the third reaction solution to prepare a solid polymer resin.

In order to prepare a polyimide-based resin powder, first, a first reaction solution is prepared using a diamine-based monomer and a dianhydride-based compound.

The first solvent for preparing the first reaction solution may be, for example, a polar aprotic organic solvent such as N,N-dimethylacetamide (DMAc), N,N-dimethylformamide (DMF), 1-methyl-2-pyrrolidinone (NMP), m-cresol, tetrahydrofuran (THF), chloroform, methyl ethyl ketone (MEK), or a mixture thereof. However, the first solvent according to an embodiment of the present disclosure is not limited thereto and other solvents may be used as the first solvent.

The specific types of the diamine-based monomer and the dianhydride-based compound have already been described and thus description of redundant information will be omitted.

According to one embodiment of the present disclosure, the first reaction solution may include polyamic acid and polyimide repeating units.

Then, a dicarbonyl-based compound is added to the first reaction solution and allowed to react to form a second reaction solution. For example, 1 to 24 hours after forming the first reaction solution, a dicarbonyl-based compound may be added to the first reaction solution. More specifically, a dicarbonyl-based compound may be added to the first reaction solution 1 to 20 hours after formation of the first reaction solution.

According to one embodiment of the present disclosure, when a dicarbonyl-based compound begins to be added to the first reaction solution, the reaction solution is called "second reaction solution".

The specific types of the dicarbonyl compound have been described and thus the description of redundant information will be omitted.

According to one embodiment of the present disclosure, the total equivalent weight of the dianhydride-based compound and the dicarbonyl-based compound may be substantially the same as the equivalent weight of the diamine-based monomer.

According to one embodiment of the present disclosure, the molar ratio of the dianhydride-based compound and the dicarbonyl-based compound may range from 5:95 to 40:60.

Then, a dehydrating agent and an imidization catalyst are added to the second reaction solution and reacted to prepare a third reaction solution.

According to one embodiment of the present disclosure, after the dehydrating agent and the imidization catalyst are added to the second reaction solution, stirring under reflux is performed at a temperature of 60°C to 80°C for 30 minutes to 2 hours. As a result, a third reaction solution may be prepared.

As the dehydrating agent, acid anhydride such as acetic anhydride, propionic anhydride, isobutyric anhydride, pivalic anhydride, butyric anhydride, or isovaleric anhydride may be used.

As the imidization catalyst, tertiary amine such as isoquinoline, β-picoline, or pyridine may be used.

Then, the third reaction solution is treated to prepare a solid polymer resin.

To prepare a solid polymer resin, a second solvent may be added to the third reaction solution. The second solvent may, for example, be ethanol, methanol, hexane, distilled water, or the like. The second solvent may be used alone or as a combination of two or more types.

When a solvent that mixes well with the first solvent and has low solubility in the polymer resin is added as the second solvent to the third reaction solution, the solid polymer resin is precipitated as a powder. The precipitate may be filtered and dried to prepare a high-purity solid polymer resin. When liquid components are removed in the process of filtering the precipitate, unreacted monomers, oligomers, additives, and reaction by-products may be removed as well.

The polymer resin thus obtained may be in a solid powder state and may include an imide repeating unit and an amide repeating unit. The polymer resin may be a polyimide-based resin, for example, a polyamide-imide-based resin. The polymer resin is also called a "polymerizable composition".

According to an embodiment of the present disclosure, a method of manufacturing the optical film 100 may include preparing a polyimide-based resin solution using a polyimide-based resin powder.

In order to prepare a polyimide-based resin solution using the polyimide-based resin powder, the polyimide-based resin powder may be dissolved in a third solvent. N,N-dimethylacetamide (DMAc) may be used as the third solvent. However, one embodiment of the present disclosure is not limited thereto and another known solvent may be used as the third solvent.

According to an embodiment of the present disclosure, a method of manufacturing the optical film 100 may include preparing a filler dispersion.

The fiber-shape filler 120, for example, the fiber-shape filler 120 having a high aspect ratio, has a long length compared to the diameter and may thus easily entangle or aggregate in the light-transmissive matrix 110. Therefore, the filler 120 requires excellent dispersibility in the filler resin mixture.

For example, the filler dispersion may be prepared by dispersing the filler 120 in a fourth solvent. The fourth solvent may include at least one of N,N-dimethylacetamide (DMAc) or methyl ethyl ketone (MEK). However, one embodiment of the present disclosure is not limited thereto and another known solvent may be used as the fourth solvent.

According to one embodiment of the present disclosure, in order for the filler 120 to have excellent dispersibility in the filler resin mixture, a filler dispersion may be prepared separately from the polyimide-based resin solution and then mixed therewith.

More specifically, the filler dispersion may, for example, include 75 to 85% by weight of DMAc (N,N-dimethylacetamide), 5 to 10% by weight of acetic acid, 2 to 7% by weight of p-toluene sulfonic acid (PTSA), and 10% by weight of the filler 120, based on the total weight of the filler dispersion.

p-Toluene sulfonic acid (PTSA) may be used as an additive to the filler dispersion to improve the dispersibility of the filler 120. However, the embodiment of the present disclosure is not limited thereto and other known additives may be used to improve the dispersibility of the filler 120.

Acetic acid may be used as a pH adjuster in the filler dispersion to prevent aggregation or agglomeration of the filler 120 and improve dispersion stability. However, the embodiment of the present disclosure is not limited thereto and another known weak acid may be used to prevent aggregation or agglomeration of the filler 120 and improve dispersion stability.

According to one embodiment of the present disclosure, the content of the filler 120 in the optical film 100 may be adjusted depending on the amount of the filler dispersion mixed when mixing the polyimide resin solution with the filler dispersion.

According to an embodiment of the present disclosure, a method of manufacturing the optical film 100 may include manufacturing the optical film 100 using the prepared filler resin mixture.

According to one embodiment of the present disclosure, to improve the dispersibility of the filler 120 in the filler resin mixture after preparing the filler resin mixture by mixing the filler dispersion with the polyimide-based resin solution, for example, the pH of the filler resin mixture may be adjusted. For example, the pH of the filler resin mixture may be adjusted to the range of 4 to 7. Accordingly, agglomeration or aggregation of the filler 120 may be prevented.

Then, the filler resin mixture is cast, dried and heat-treated to form an optical film 100. According to one embodiment of the present disclosure, the film formed by casting the filler resin mixture may be referred to as a "cast film" and the film produced by drying and heat-treating the cast film may be referred to as an "optical film 100". The cast film can be referred to as an "uncured film".

In addition, convection may be prevented during drying and heat treatment of the cast film formed by casting, so that the filler 120 may be oriented in a certain direction.

Specifically, when convection is generated inside the cast film that is dried using heat, the orientation of the filler 120 may decrease. Thus, the cast film may be allowed to be dried slowly to prevent convection. For example, drying of the cast film may be performed while raising the temperature from 80°C to 120°C at a rate of 1°C/1 min. When drying is performed over a certain level, the orientation of the filler 120 may be fixed.

The optical film 100 according to an embodiment of the present disclosure may be manufactured in accordance with the method.

Hereinafter, the present disclosure will be described in more detail with reference to Preparation Example and Example. However, the following Preparation example and Example should not be construed as limiting the scope of the present disclosure.

### <Preparation Example: Preparation of polymer-imide-based polymer solid>

701.979 g of N,N-dimethylacetamide (DMAc) was charged in a 1L reactor equipped with a stirrer, a nitrogen injector, a dropping funnel, a temperature controller, and a cooler while the reactor was purged with nitrogen. Then, the temperature of the reactor was adjusted to 25°C, 54.439 g (0.17 mol) of bis(trifluoromethyl)benzidine (TFDB) was dissolved therein and the temperature of the solution was maintained at 25°C. 5.668 g (0.029 mol) of 1,2,3,4-cyclobutanetetracarboxylic dianhydride (CBDA) was added thereto, and then completely dissolved by stirring for 3 hours. Then, 12.839 g (0.029 mol) of 2,2-bis(3,4-dicarboxyphenyl)hexafluoropropane dianhydride (6FDA) was added thereto and completely dissolved therein. After lowering the reactor temperature to 10°C, 22.779 g (0.112 mol) of terephthaloyl chloride (TPC) was added thereto and reacted at 25°C for 12 hours to obtain a polymer solution with a solid concentration of 12% by weight.

10.06 g of pyridine and 12.99 g of acetic anhydride were added to the obtained polymer solution, stirred for 30 minutes, heated at 80°C, stirred at the same temperature for 1 hour to allow a reaction to occur, and allowed to cool to room temperature. 20L of methanol was added to the obtained polymer solution to precipitate a solid. The precipitated solid was filtered, pulverized, washed with 2L of methanol, and dried under vacuum at 100°C for 6 hours or longer to prepare a polyimide-based polymer solid as a powder. The prepared polyimide-based polymer solid is a polyamide-imide polymer solid, which is called a "polymerizable composition".

### <Example 1>

723.46 g of DMAc (first solvent) was added to a 1 L reactor and the reactor was stirred for a predetermined period of time while the temperature of the reactor was maintained at 10°C. Then, 110 g of polyamide-imide (polyimide-based resin powder) prepared as the solid powder in Preparation Example was added to the reactor, stirred for 1 hour, and heated to 25°C to prepare a polyimide-based resin solution.

In addition, a filler dispersion was prepared separately from the polyimide resin solution. An aluminum oxide hydroxide fiber dispersion was prepared as the filler dispersion.

More specifically, based on the total weight of the filler dispersion, a filler dispersion containing 80% by weight of DMAc (N,N-dimethylacetamide, second solution), 5% by weight of acetic acid, 5% by weight of p-toluene sulfonic acid (PTSA), and 10% by weight of the filler 120 was prepared. Here, the filler 120 used herein was an aluminum oxide hydroxide fiber having an average diameter of 4 nm and an average length of 1,500 nm.

55 g of the prepared filler dispersion was slowly added to the prepared liquid polyimide resin solution for 1 hour using a cylinder pump to prepare a filler resin mixture containing the filler dispersion and the polyimide resin solution. The filler dispersion was used such that the content of the filler 120 was 10% by weight based on the total weight of the solid content (polyimide resin component + filler).

The pH of the filler resin mixture immediately after preparation was measured. As a result, the pH was higher than 7. In order to improve the dispersion and arrangement characteristics of the filler 120, a weak acid such as acetic acid was added to the filler resin mixture to adjust the pH of the filler resin mixture to a range of 4 to 7, specifically pH 6.5. The filler resin mixture thus prepared was a polyimide-based resin solution in which the fiber-shape filler 120 is dispersed.

The obtained filler resin mixture was cast. A casting substrate was used for casting. At this time, there is no particular limitation on the type of the casting substrate. The casting substrate may be a glass substrate, a stainless steel (SUS) substrate, a Teflon substrate, or the like. According to one embodiment of the present disclosure, a glass substrate was used as the casting substrate.

Specifically, the obtained filler resin mixture was applied to a glass substrate and casted. In order to improve the orientation of the filler 120, the filler resin mixture was applied to a glass substrate (casting substrate) and then cast while applying a force of 30 N in a direction perpendicular to the glass substrate. As a result, a cast film was produced.

Specifically, the cast film was produced by slowly drying in a hot air oven at 80°C up to 120°C at a rate of 1°C/1min for about 40 minutes to maintain the orientation of the filler 120. Then, the produced film was peeled off of the glass substrate and fixed to a frame with pins.

The frame to which the optical film was fixed was slowly heated in a vacuum oven from 100°C to 280°C for 2 hours, cooled slowly and separated from the frame to obtain an optical film. The optical film was heated again at 250°C for 5 minutes.

As a result, an optical film 100 having a thickness of 50 µm and including the light-transmitting matrix 110 and the filler 120 dispersed in the light-transmitting matrix 110 was completed.

### <Examples 2 and 3>

The optical films 100 were produced under the conditions of Table 1 in the same manner as in Example 1 and were respectively referred to as "Examples 2 and 3".

### <Comparative Example 1>

An optical film 100 was produced under the conditions of Table 1 in the same manner as in Example 1 except that the filler 120 was not added and the pH of the first mixed solution was changed, and was referred to as "Comparative Example 1".

### <Comparative Examples 2 to 5>

Optical films 100 were manufactured in the same manner as in Example 1, except that the type and content of the filler 120 and the pH of the first mixed solution were changed, and the optical films 100 are referred to as Comparative Examples 2 to 5.

**[Table 1]**

| Item | Light-transmitting matrix (molar ratio) | | | | Type of filler | First mixed solution (pH) | Content of filler (wt%) |
|---|---|---|---|---|---|---|---|
| | Diamine | Dianhydride | | Dicarbonyl | | | |
| | TFDB | 6FDA | CBDA | TPC | | | |
| Example 1 | 100 | 17 | 17 | 66 | Filler 1 | 6.5 | 5% |
| Example 2 | 100 | 17 | 17 | 66 | Filler 1 | 5.9 | 10% |
| Example 3 | 100 | 17 | 17 | 66 | Filler 1 | 5.7 | 20% |
| Compara tive Example 1 | 100 | 17 | 17 | 66 | Not added | 7.3 | - |
| Compara tive Example 2 | 100 | 17 | 17 | 66 | Filler 2 | 7.0 | 5% |
| Compara tive Example 3 | 100 | 17 | 17 | 66 | Filler 2 | 7.1 | 10% |
| Compara tive Example 4 | 100 | 17 | 17 | 66 | Filler 2 | 6.9 | 20% |
| Compara tive Example 5 | 100 | 17 | 17 | 66 | Filler 2 | 6.7 | 40% |

In Table 1, filler 1 is an aluminum oxide hydroxide fiber filler having a diameter (A) of 4 nm, a length (B) of 1,500 nm, and B/A of 375, and filler 2 is a spherical nanoparticle having a particle diameter of 15 nm.

In Table 1, the molar ratio means a molar ratio based on a total of 100 moles of diamine.

In Table 1, weight % means weight % of a filler based on the total weight of the optical film.

### <Measurement of physical properties>

The following physical properties of the 50 µm thick optical films manufactured in Examples 1 to 3 and Comparative Examples 1 to 5 were measured.

### (1) Measurement of true density

An optical film sample with a size of 10 X 10 cm² manufactured in each of Examples 1 to 3 and Comparative Examples 1 to 5 was produced. The optical film sample (10 X 10 cm²) was cut into fragments of smaller than a size with 1 X 1 cm² and the fragments were placed in a sample holder along with a steel bead (grinder). At least 2/3 of a cryogenic sample crusher (Japan Analytical Industry, JFC-300) was filled with liquid nitrogen, a sample holder containing the optical film fragments was connected to the cryogenic sample crusher, the chamber was closed, and the fragments were pre-cooled for 15 minutes and pulverized for 15 minutes or longer using the cryogenic sample crusher. The true density of the pulverized optical film sample was measured seven times using an AccuPyc 1340 Pycnometer from Micromeritics (using helium gas). The true density of the optical film was determined by calculating an average of the true density values excluding the highest and lowest values from among the measured true density values of the optical film.

### (2) Measurement of Martens hardness (HM)

The optical films manufactured in Examples 1 to 3 and Comparative Examples 1 to 5 were pressed with a pyramidal diamond tip with a diagonal of 90 degrees in accordance with ISO 14577-1, and the surface hardness was measured based on the indentations created. The Martens hardness of the optical film was obtained by calculating HM = A/B wherein A is a pressing load (kg) and B is a surface area (mm²), and converting the result into MPa. Martens hardness was measured using HM-2000 from Fisher Scientific International, Inc. as a Martens hardness tester.
- Force: 12 mN
- Running Time: 12 s
- Hold Time: 5 s

### (3) Measurement of Vickers hardness (HV)

The optical films manufactured in Examples 1 to 3 and Comparative Examples 1 to 5 were pressed with a pyramidal diamond tip with a diagonal of 136 degrees in accordance with ISO 14577-1, and the surface hardness of the indentations created was measured. The Vickers hardness of the optical film was obtained by calculating HV = C/D wherein C is a pressing load (kg) and D is a surface area (mm²), and converting the result into MPa. Vickers hardness was measured using HM-2000 from Fisher Scientific International, Inc. as a Vickers hardness tester.
- Force: 12 mN
- Running Time: 12 s
- Hold Time: 5 s

### (4) Measurement of 1 mm dent strength

An optical film sample with a size of 60 X 60 cm² manufactured in each of Examples 1 to 3 and Comparative Examples 1 to 5 was produced. The optical film sample was placed on a fixture with a circular hole in the center and then the sample for the optical film 100 was fixed with a clamp. The sample for the optical film 100 was pressed with a probe having a cylindrical head with a diameter of 1.59 mm mounted on a universal testing machine in the vertical direction at a speed of 5 mm/min. The force measured upon pressing from the point where a force of 1N was applied to the probe as a reference point to a depth of 1 mm was measured as the 1 mm dent strength of the optical film 100.

### (5) Measurement of restoration rate (nIT)

The restoration rate of the optical film 100 manufactured in each of Examples 1 to 3 and Comparative Examples 1 to 5 was measured at a temperature of 24°C and at a humidity of 40 RH% using a nanoindenter, the optical film 100 was measured at a temperature of 24°C and at a humidity of 40 RH%, a load of 12 mN was applied to the optical film 100 and pressed for 12 seconds, the optical film 100 was allowed to stand for 5 seconds at the maximum pressed point, and the degree to which the optical film 100 was depressed was measured when the applied load was reversely removed (12 mN/12 s/creep 5 s/24°C, 40 RH%).

The results of measurement are shown in Table 2.

**[Table 2]**

| Item | True density (g/cm³) | HM (MPa) | HV | 1 mm Dent strength(N) | Restoration rate (nIT, %) |
|---|---|---|---|---|---|
| Example 1 | 1.5502 | 245 | 46.3 | 10.78 | 67.4 |
| Example 2 | 1.5900 | 257 | 47.8 | 11.96 | 66.0 |
| Example 3 | 1.6602 | 271 | 49.0 | 12.78 | 63.7 |
| Compara tive Example 1 | 1.5024 | 212 | 40.1 | 9.69 | 69.0 |
| Compara tive Example 2 | 1.5182 | 180 | 40.4 | 9.87 | 66.2 |
| Compara tive Example 3 | 1.5340 | 179 | 41.1 | 10.19 | 64.8 |
| Compara tive Example 4 | 1.5655 | 209 | 43.7 | 10.38 | 59.1 |
| Compara tive Example 5 | 1.6602 | 190 | 45.5 | 10.55 | 58.5 |

As can be seen from results of measurement in Table 2, all the optical films 100 according to embodiments of the present disclosure have HM of 225 MPa or more and HV of 46 or more, which means that they have excellent surface properties. In addition, it can be seen that the 1 mm dent strength is 10.7 N or more, indicating excellent dent resistance.

### [Explanation of reference numerals]

- 100:: Optical film
- 110:: Light-transmitting matrix
- 120:: Filler
- 200:: Display device
- 501:: Display panel

## Claims

1. An optical film comprising:
a light-transmitting matrix; and
a filler dispersed in the light-transmitting matrix,
the optical film having a 1 mm dent strength of 10.7 N or more, based on a thickness of 50 µm,
wherein the 1 mm dent strength refers to a force of the optical film to resist compression with a probe provided in a universal testing machine at a rate of 5 mm/min in a vertical direction from a point where a force of 1N is applied to a depth of 1 mm.

2. The optical film according to claim 1, wherein the filler has a rod or fiber shape.

3. The optical film according to claim 2, wherein the filler has a length of 1 to 10 µm.

4. The optical film according to claim 2, wherein the filler has a diameter of 3 to 330 nm.

5. The optical film according to claim 2, wherein the filler has an aspect ratio of 30 to 1,000,
wherein the aspect ratio is a ratio of a length of the filler to a diameter of the filler.

6. The optical film according to claim 1, wherein the filler comprises at least one of glass fiber, an aluminum-based fiber, titanium fiber or fluoride fiber.

7. The optical film according to claim 1, wherein the filler comprises aluminum oxide hydroxide.

8. The optical film according to claim 1, wherein a content of the filler is 3 to 50 wt% based on a total weight of the optical film.

9. The optical film according to claim 1, wherein the optical film has a true density of 1.55 to 1.67 g/cm³.

10. The optical film according to claim 1, wherein the optical film has an HM of 220 MPa or more based on a thickness of 50 µm,
wherein the HM represents a Martens hardness of the optical film, and
the HM is measured using HM-2000 at a force of 12 mN for a running time of 12s and for a hold time of 5s.

11. The optical film according to claim 1, wherein the optical film has an HV of 46 MPa or more,
wherein the HV represents a Vickers hardness of the optical film, and
the HV is measured using HM-2000 at a force of 12 mN for a running time of 12 s and for a hold time of 5 s.

12. The optical film according to claim 1, wherein the optical film has a restoration rate (nIT) of 60 to 100%,
wherein the restoration rate is measured using a nanoindenter under the conditions of 12 mN/12s/creep 5s/24°C, 40 RH%.

13. The optical film according to claim 1, wherein the light-transmitting matrix comprises at least one of an imide repeating unit or an amide repeating unit.

14. The optical film according to claim 1, wherein the light-transmitting matrix is produced from a polymerizable composition comprising:
a diamine-based monomer; and
at least one of a dianhydride-based compound or a dicarbonyl-based compound.

15. The optical film according to claim 14, wherein the diamine-based monomer comprises at least one of 2,2'-bis(trifluoromethyl)benzidine (TFDB), 4,4'-oxydianiline (ODA), p-phenylenediamine (pPDA), m-phenylenediamine (mPDA), p-methylenediamine (pMDA), m-methylenediamine (mMDA), 1,3-bis(3-aminophenoxy)benzene (133APB), 1,3-bis(4-aminophenoxy)benzene (134APB), 2,2'-bis[4(4-aminophenoxy)phenyl]hexafluoropropane (4BDAF), 2,2'-bis(3-aminophenyl) hexafluoropropane (33-6F), 2,2'-bis(4-aminophenyl) hexafluoropropane (44-6F), bis(4-aminophenyl) sulfone (4DDS), bis(3-aminophenyl)sulfone (3DDS), 1,3-cyclohexanediamine (13CHD), 1,4-cyclohexanediamine (14CHD), 2,2-bis(4-(4-aminophenoxy) phenyl) propane (6HMDA), 2,2-bis(3-amino-4-hydroxyphenyl)hexafluoropropane (DBOH), or 4,4'-bis(3-aminophenoxy)diphenylsulfone (DBSDA).

16. The optical film according to claim 14, wherein the dianhydride-based compound comprises at least one of 3,3,4,4-biphenyltetracarboxylic dianhydride (BPDA), 2,2-bis(3,4-dicarboxyphenyl)hexafluoropropane dianhydride (6FDA), 4-(2,5-dioxotetrahydrofuran-3-yl)-1,2,3,4-tetrahydronaphthalene-1,2-dicarboxylic anhydride (TDA), pyromellitic dianhydride (1,2,4,5-benzene tetracarboxylic dianhydride, PMDA), 3,3,4,4-benzophenone tetracarboxylic dianhydride (BTDA), 4,4-oxydiphthalic dianhydride (ODPA), bis(3,4-dicarboxyphenyl)dimethyl-silane dianhydride (SiDA), 4,4-bis(3,4-dicarboxyphenoxy) diphenyl sulfide dianhydride (BDSDA), sulfonyldiphthalic anhydride (SO2DPA), cyclobutane-1,2,3,4-tetracarboxylic dianhydride (CBDA), or 4,4'-(4,4'-isopropylenediphenoxy) bis(phthalic anhydride) (6HBDA).

17. The optical film according to claim 14, wherein the dicarbonyl-based compound comprises at least one of terephthaloyl chloride (TPC), phthaloyl chloride, isophthaloyl chloride (IPC), biphenyldicarbonyl chloride (DPDOC), 4,4'-oxybis(benzoyl chloride) (OBBOC), naphthalene-2,3-dicarbonyl dichloride, or 1,4-cyclohexanedicabonyldichloride (CHDOC).

18. The optical film according to claim 14, wherein a molar ratio of the dianhydride-based compound and the dicarbonyl-based compound is 5:95 to 40:60.

19. A display device comprising:
a display panel; and
the optical film according to any one of claims 1 to 18 disposed on the display panel.
